(19) **Europäisches Patentamt**
**European Patent Office**
**Office européen des brevets**

(11) **EP 3 702 321 B1**

(12) **FASCICULE DE BREVET EUROPEEN**

(45) Date de publication et mention
de la délivrance du brevet:
**24.05.2023 Bulletin 2023/21**

(21) Numéro de dépôt: **20155328.6**

(22) Date de dépôt: **04.02.2020**

(51) Classification Internationale des Brevets (IPC):
***B81B 3/00*** *(2006.01)*

(52) Classification Coopérative des Brevets (CPC):
**B81B 3/0021;** B81B 2201/042; B81B 2203/0154;
B81B 2203/058; B81B 2207/07

(54) **DISPOSITIF MICROMECANIQUE A BOBINE**

MIKROMECHANISCHE VORRICHTUNG MIT SPULE

MICROMECHANICAL DEVICE WITH COIL

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **26.02.2019 CH 2322019**

(43) Date de publication de la demande:
**02.09.2020 Bulletin 2020/36**

(73) Titulaire: **Sercalo Microtechnology Ltd.
9494 Schaan (LI)**

(72) Inventeurs:
• **Marxer, Cornel
2000 Neuchâtel (CH)**

• **Kuenlin, Vincent
2000 Neuchâtel (CH)**

(74) Mandataire: **Swisspat Riederer Hasler
Patentanwälte AG
Kappelestrasse 15
9492 Eschen (LI)**

(56) Documents cités:
**EP-A1- 3 021 155          EP-B1- 2 990 375
WO-A1-2013/065126          JP-A- 2004 198 647
US-A1- 2002 050 744**

## Description

La présente invention est relative aux microsystèmes électromécaniques, plus connus sous l'appellation MEMS de l'anglais Micro Electro Mechanical Systems. Elle concerne plus précisément un dispositif micromécanique comportant un actuateur mobile selon au moins un axe de rotation, et des moyens d'actionnement de cet actuateur de type électromagnétique.

De tels dispositifs sont généralement des dispositifs optiques dont l'actuateur est constitué d'un miroir relié à un cadre fixe par l'intermédiaire de deux poutres élastiques en torsion définissant l'axe de rotation du miroir. En variante, l'actuateur est mobile selon deux axes de rotation. Le miroir est alors relié à un premier cadre mobile à l'aide de deux poutres de torsion, lequel est lui même relié au cadre fixe par l'intermédiaire de deux autres poutres de torsion. Qu'il soit mobile selon un ou deux axes de rotation, le miroir ainsi monté permet de dévier un faisceau lumineux entre différentes positions angulaires fixes ou de balayer un espace angulaire à l'aide d'un faisceau lumineux. De tels dispositifs équipent notamment des spectromètres optiques, des imprimantes, des appareils d'imagerie médicale, des capteurs de lumière et bien d'autres appareils comportant une commande optique.

Parmi les dispositifs susmentionnés, on s'intéresse aux dispositifs actionnés de manière électromagnétique à l'aide d'un rotor monté solidaire en rotation de l'actuateur, et d'un stator comprenant deux pôles magnétiques opposés séparés par un entrefer dans lequel prend place le rotor. De tels dispositifs sont décrits en détail, ainsi que leur fonctionnement, dans le document EP 2 990 375 B1. Plus particulièrement, on s'intéresse ici à des dispositifs dans lesquels le rotor est constitué d'une bobine de fil montée sur un cadre mobile, lequel est solidaire en rotation de l'actuateur. Le cadre mobile est relié à un cadre fixe par l'intermédiaire de deux poutres de torsion définissant l'axe de rotation de l'actuateur. Dans une telle configuration, l'alimentation du bobinage pose problème. En effet, le courant doit être amené depuis deux points fixes, généralement deux plots d'alimentation sur le cadre fixe, vers la bobine mobile en rotation, cela sans perturber significativement le mouvement de l'actuateur. La difficulté provient ici des dimensions respectives du fil constituant la bobine et des poutres de torsion. Le diamètre du fil est généralement d'une centaine de microns, de manière à éviter tout risque de rupture au montage et en fonctionnement. La largeur des poutres se situe, elle, autour de cinquante microns, pour une longueur de l'ordre du millimètre, ce qui confère aux poutres une constante de torsion optimale par rapport aux forces de torsion générées par le rotor et le stator. Il en résulte qu'avec un diamètre du fil équivalent à deux fois la largeur des poutres de torsion, le fil de la bobine ne peut pas transiter par les poutres de torsion pour rejoindre des plots d'alimentation sur le cadre fixe, sans perturber gravement le mouvement de rotation de l'actuateur. Dans l'état de la technique, les fils de la bobine ne passent donc pas par les poutres de torsion, mais, pour autant, la jonction entre la bobine et les plots d'alimentation n'est pas optimisée. Le cadre mobile solidaire en rotation de l'actuateur est généralement rectangulaire, et les fils de la bobine sortent de celui-ci par deux points quelconques. Ils rejoignent ensuite les plots d'alimentation de manière à ne pas bloquer le mouvement de rotation de l'actuateur, mais sans plus de précaution. Le document WO2013065126 divulgue un dispositif selon le préambule de la revendication 1.

Or, ainsi agencés, les fils sortant perturbent sensiblement le mouvement de rotation de l'actuateur, et de plus, ils le font de façon non contrôlée et non reproductible. Le fonctionnement du dispositif micromécanique est ainsi impacté en son coeur, et il est très difficile de prévoir qualitativement et quantitativement l'effet de la perturbation. La présente invention a pour but de remédier à cet inconvénient en proposant un dispositif micromécanique comprenant un actuateur monté mobile en rotation, au moins un rotor formé d'une bobine de fil montée solidaire en rotation dudit actuateur, au moins un stator et un cadre fixe muni de deux plots d'alimentation, dans lequel la jonction entre les fils de la bobine et les plots d'alimentation sur le cadre fixe est conçue pour minimiser les perturbations du mouvement de rotation de l'actuateur. Plus précisément, la présente invention concerne un dispositif micromécanique à bobine comportant un cadre fixe, un actuateur monté mobile selon un axe de rotation AA sur le cadre fixe par l'intermédiaire de deux poutres de torsion d'axe AA, et un rotor formé d'une bobine de fil conducteur montée solidaire en rotation de l'actuateur, ladite bobine étant alimentée en courant depuis le cadre fixe via ses deux brins de fil terminaux lesquels sont reliées à des plots d'alimentation disposés sur le cadre fixe. Selon l'invention, les dimensions et la géométrie des brins de fil terminaux sont choisies pour que leur constante de raideur $k_{segments}$ soit petite devant la constante de raideur $k_p$ des poutres et pour que leur moment d'inertie de rotation $I_{segments}$ soit petit devant le moment de rotation $I_a$ de l'actuateur. Grâce à cet agencement des brins de fil terminaux, et comme il apparaîtra dans la suite de cet exposé, le mouvement de rotation de l'actuateur est faiblement impacté par le transit du courant du cadre fixe à la bobine mobile en rotation, et la fiabilité du dispositif micromécanique selon l'invention s'en trouve améliorée. La présente invention concerne également un dispositif micromécanique à bobine comportant un cadre fixe, un actuateur monté mobile selon un axe de rotation AA sur le cadre fixe par l'intermédiaire de deux poutres de torsion d'axe AA, et un rotor formé d'une bobine de fil conducteur montée solidaire en rotation de l'actuateur, la bobine étant alimentée en courant depuis le cadre fixe via deux segments conducteurs lesquels sont reliés à des plots d'alimentation disposés sur le cadre fixe. Selon l'invention, les segments conducteurs sont formés par deux pistes métalliques s'étendant sur au moins une poutre de torsion et les deux extrémités de la bobine sont soudées chacune à l'une des pistes métalliques de part et d'autre de l'une des poutres de torsion. Le silicium étant rendu isolant par une fine couche diélectrique tel qu'un dioxyde de silicium, un nitrure de silicium our une autre fine couche. Grâce au soudage des extrémités de la bobine à des pistes métalliques rejoignant des plots d'alimentation sur le cadre fixe via les poutres de torsion, le mouvement de rotation de l'actuateur n'est pas sensiblement perturbé par le passage du courant du cadre fixe au cadre mobile.

Un dispositif selon l'invention est défini dans la revendication 1.

Les caractéristiques et les avantages de la présente invention apparaîtront plus clairement à la lecture de la description qui suit, donnée uniquement à titre d'exemple, et faite en référence aux dessins annexés dans lesquels :

- La figure 1 est une vue schématique de dessus d'un premier dispositif micromécanique à bobine comportant un actuateur mobile selon un axe de rotation,
- La figure 2 est une vue schématique de dessus d'une variante du premier dispositif micromécanique à bobine,
- La figure 3 est une vue schématique de dessus d'un dispositif micromécanique à bobine, comportant un actuateur mobile selon deux axes de rotation,
- La figure 4 illustre schématiquement une vus de dessus d'un mode de réalisation d'un dispositif micromécanique à bobine selon l'invention,
- Les figures 5a et 5b sont des vues schématiques en coupe selon un axe BB du mode de réalisation d'un dispositif micromécanique à bobine pris en deux étape différentes du procédé de fabrication, et

La figure 6 est une vue schématique de dessus d'une variante d'un dispositif micromécanique à bobine.

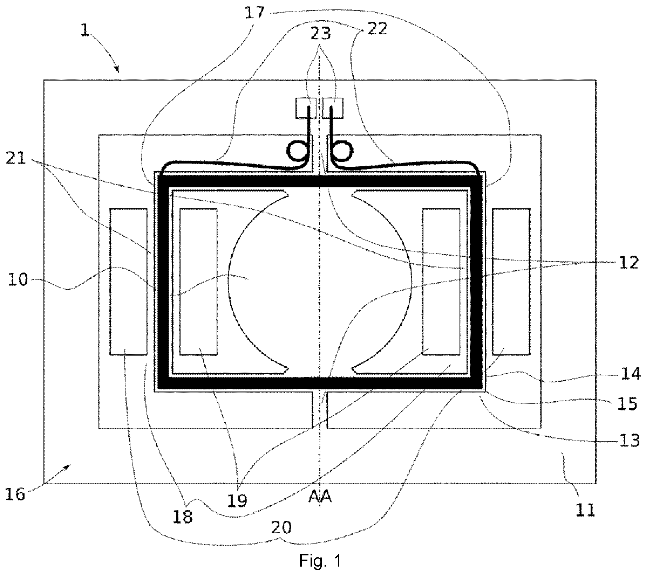

Le dispositif micromécanique à bobine représenté en figure 1, et référencé dans son ensemble 1, comprend classiquement un actuateur 10, monté mobile en rotation selon un axe de rotation AA sur un cadre fixe 11, par l'intermédiaire de deux poutres de torsion 12. L'actuateur 10 est un élément optiquement actif, tel qu'un miroir, un réseau de diffraction, une lentille ou tout autre composant destiné à interagir avec un faisceau lumineux. Il est monté solidaire en rotation d'un rotor 13 formé d'un cadre mobile 14 surmonté d'une bobine de fil conducteur 15. L'ensemble composé de l'actuateur 10, du cadre fixe 11, des poutres de torsion 12 et du cadre mobile 14 est fabriqué d'une seule pièce 16 à partir d'une plaquette de SIO (de l'anglais Silicon On Oxide), par des opérations de photolithographie, et est connu sous l'appellation de MEMS (de l'anglais Micro Electro Mechanical System). La dimension de l'ensemble est de l'ordre du centimètre carré.

Classiquement, le rotor 13 est de géométrie sensiblement rectangulaire ou carrée, et comprend deux côtés 17 disjoints de l'actuateur 10, parallèles à l'axe de rotation AA et symétriques par rapport à ce même axe de rotation AA. Deux stators 18 comportant chacun deux pôles opposés 19, 20 séparés l'un de l'autre par un entrefer 21, sont disposés au voisinage du rotor 13, de manière à recevoir chacun dans son entrefer 21, un côté 17 du rotor 13. Le passage du courant dans le rotor 13, combiné au champ magnétique $\vec{B}$ régnant dans les entrefers 21, crée une force de Laplace $\vec{F}$ entraînant le rotor 13 et l'actuateur 10 en rotation autour de l'axe AA. Selon l'application du dispositif micromécanique à bobine 1, ce mouvement de rotation se fait en mode statique ou dynamique. Quel que soit le mode de fonctionnement choisi, le mouvement de rotation de l'ensemble actuateur 10 - poutre 12 dépend du moment de torsion $M_p$ des poutres 12 et du moment d'inertie $I_a$ de l'actuateur 10. Ces grandeurs sont caractéristiques de l'ensemble actuateur 10 - poutres de torsion 12 et dépendent de leur géométrie, de la répartition spatiale de la masse et du matériau qui les constitue. Plus précisément, le moment de torsion $M_p$ des poutres 12 est lié à leur constante de raideur $k_p$, par la relation suivante :

$$M_p = 2.k_p.\alpha \qquad (1)$$

où $\alpha$ est l'angle de rotation de l'actuateur 10. La constante de raideur $k_p$ est fixée par les dimensions des poutres de torsion 12 et par le coefficient d'élasticité du silicium. Ainsi, les dimensions et la géométrie de l'actuateur 10, des poutres de torsion 12 et de l'ensemble du MEMS 16 sont prévues pour un fonctionnement déterminé du dispositif 1 pour une application donnée.

La bobine 15 est, elle, formée d'un enroulement d'un fil conducteur, typiquement en cuivre ou en aluminium, épousant la géométrie du cadre mobile 14. Elle se termine en ses extrémités par deux brins 22 sortant de l'enroulement pour aller contacter deux plots d'alimentation 23 disposés sur le cadre fixe 11, assurant ainsi le passage du courant de la pièce fixe, le cadre fixe 11, à la pièce mobile, le rotor 13. La conception de la bobine 15 et de ses deux brins 22 sortant, obéit à des contraintes mécaniques, électriques et géométriques imposées par le fonctionnement du dispositif 1. Ces contraintes sont les suivantes, par ordre d'importance décroissant : La bobine 15 doit conduire le courant électrique, le fil doit être suffisamment résistant mécaniquement pour ne pas casser au montage ou en fonctionnement, et enfin, les deux brins 22 sortant de l'enroulement doivent perturber au minimum le mouvement de rotation de l'actuateur 10. Les deux premières contraintes imposent que le fil est en métal conducteur, typiquement de l'aluminium ou du cuivre, et que son diamètre est de 50 à 100 micromètres au moins (en fonction du métal). En dessous de cette valeur, le fil casse dès le montage. Par la suite, une valeur de 100 micromètres sera utilisée.

La dernière contrainte est plus complexe à mettre en oeuvre. En effet, les brins 22 ainsi sortant de l'enroulement ont un moment de torsion $M_{fil}$ et un moment d'inertie $I_{fil}$ venant s'ajouter respectivement au moment de torsion $M_p$ des poutres et au moment d'inertie $I_a$ de l'actuateur 10. Afin de perturber le moins possible le mouvement de rotation de l'actuateur 10, l'agencement des brins 22 de fil sortant est prévu pour que les moments de torsion $M_{fil}$ et d'inertie $I_{fil}$ du fil sortant soient petits devant, respectivement, le moment de torsion des poutres $M_p$ et le moment d'inertie de l'actuateur $I_a$. Pour commencer, le moment de torsion du fil $M_{fil}$ est lié à sa constante de raideur $k_{fil}$ par la relation (1) de sorte qu'il prend une valeur minimale pour une constante de raideur $k_{fil}$ minimale. Or la constante de raideur $k_{fil}$ du fil est faible pour une longueur du fil grande et pour un diamètre petit. Le diamètre étant fixé à 100 micromètres au minimum en raison des contraintes mécaniques, la longueur de brins 22 de fil sortant est choisie grande pour minimiser la constante de raideur $k_{fil}$. Par grande, on entend une longueur d'au moins un ordre de grandeur plus grande que la longueur des poutres de torsion 12. Par ailleurs, le moment d'inertie $I_{fil}$ des brins 22 de fil sortant est minimisé pour une masse faible et répartie essentiellement au voisinage de l'axe de rotation AA du système. La masse dépend de la longueur et du diamètre des brins 22 de fil sortant, et est donc fixée par les contraintes précédentes. Quant à sa répartition autour de l'axe AA, elle est donnée par la géométrie des brins 22 de fil sortant qui est optimisée en ce sens.

En effectuant la synthèse des éléments précédents, on parvient à un agencement optimal des brins 22 de fil sortant : Les brins 22 sortent de la bobine 15 par deux coins du cadre mobile 14, symétriques par rapport à l'axe AA, et viennent contacter les plots d'alimentation 23 situés sur le cadre fixe 11 symétriquement par rapport à l'axe AA, de part et d'autre de la poutre de torsion 12 jouxtant lesdits coins. De plus, les brins 22 sortant forment une boucle au voisinage de cette poutre de torsion 12. Ainsi, la longueur des brins 22 sortant est grande devant celle des poutres de torsion 12, et leur centre de gravité est proche de l'axe AA. En variante, les brins 22 sortant forment une sinusoïde au voisinage de la poutre de torsion 12, ou une hélice ou tout autre figure permettant de ramener l'essentiel de la masse des brins 22 au voisinage de l'axe AA. Ainsi agencés, les brins 22 de fil sortant possèdent une constante de raideur $k_{fil}$ et un moment d'inertie $I_{fil}$ faibles devant respectivement la constante de raideur $k_p$ des poutres 12 et le moment d'inertie $I_a$ de l'actuateur 10.

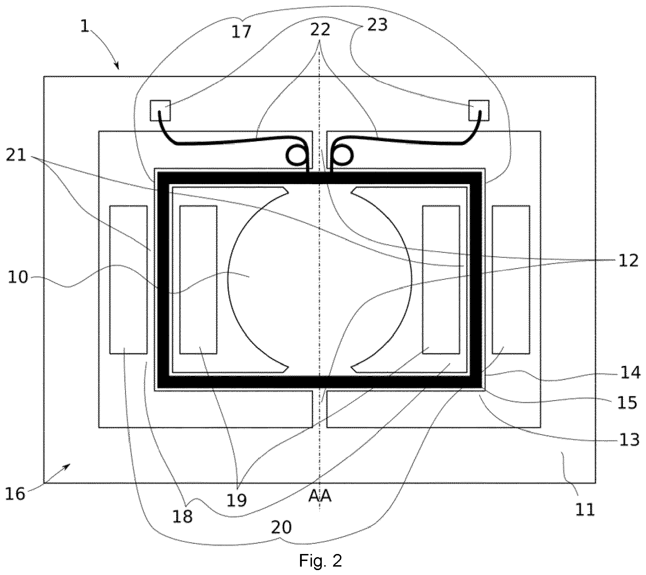

On a représenté en figure 2, une variante du dispositif micromécanique à bobine 1 qui se distingue du mode de réalisation représenté en figure 1 par le positionnement des points de sortie des brins 22 et des plots d'alimentation 23, mais se comporte de façon identique. En effet, les brins 22 sortent de la bobine 15 par deux points situés symétriquement par rapport à l'axe AA, au voisinage immédiat de l'une des poutres de torsion 12, et rejoignent les plots d'alimentation 23 situés sur le cadre fixe 11 symétriquement par rapport à l'axe AA éloignés de ladite poutre de torsion. Comme dans le mode de réalisation précédent, les brins 22 de fil sortant forment une boucle, une sinusoïde ou une hélice au voisinage de la poutre de torsion 12. De la sorte, les brins 22 de fil sortant sont grands par rapport à la longueur des poutres de torsion 12 et leur masse est répartie au voisinage de l'axe AA. Ils présentent des caractéristiques similaires au système précédent en terme de constante de raideur et de moment d'inertie.

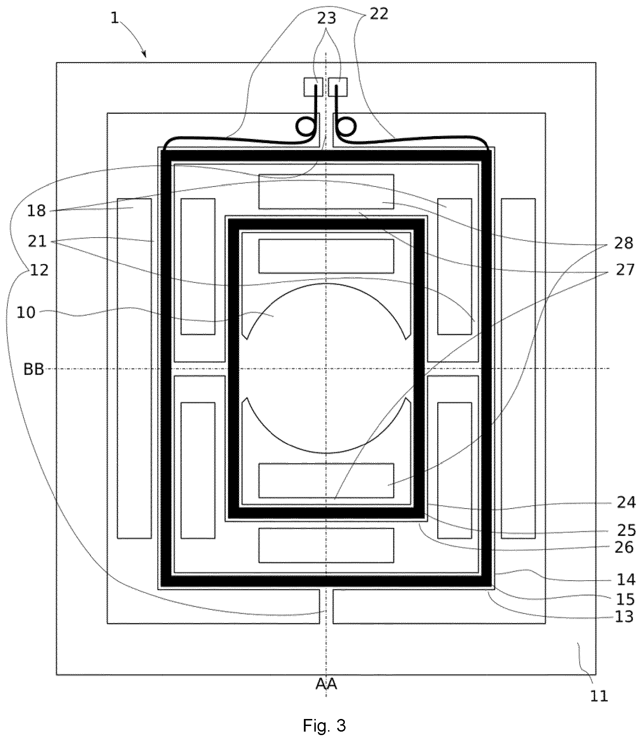

Le dispositif micromécanique à bobine 1 représenté en figures 1 et 2 comporte un actuateur 10 mobile selon un axe de rotation AA. La figure 3 illustre un tel dispositif micromécanique 1. L'actuateur 10 est monté solidaire en rotation d'un premier cadre mobile 14, d'axe de rotation AA, surmonté d'une bobine 15, et d'un deuxième cadre mobile 24, d'axe de rotation BB perpendiculaire à AA, surmonté d'une ligne conductrice 25. Le premier cadre mobile 14 forme avec la bobine 15 un premier rotor 13, tandis que le deuxième cadre mobile 24 forme avec la ligne conductrice 25 un deuxième rotor 26. Chacun des deux rotors 13 et 26 est pris dans les entrefers, respectivement 21 et 27, de stators fixes 18 et 28, à la manière décrite en regard de la figure 1. Le fonctionnement de ce dispositif micromécanique à bobine 1 est similaire à celui d'un dispositif à un axe de rotation, à cela près que l'actuateur balaie une surface et non une ligne.

La bobine 15 se termine par deux brins 22 de fil sortant dont l'agencement, les dimensions et la géométrie sont les mêmes que déjà décrit en regard des figures 1 et 2. Ils rejoignent ainsi des plots d'alimentation 23 sur le cadre fixe 11 en perturbant au minimum le mouvement de rotation de l'actuateur 10 selon l'axe AA. Le principe et la fonctionnalité sont identiques à ceux d'un dispositif micromécanique à bobine 1 à un axe de rotation.

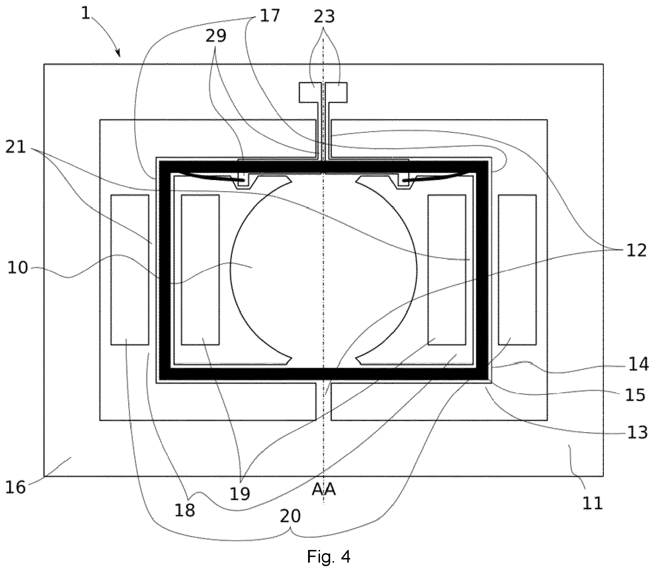

On se réfère maintenant à la figure 4 qui représente un mode de réalisation d'un dispositif micromécanique 1 selon l'invention. Ce deuxième mode de réalisation se distingue du premier en ce que la bobine 15 ne comporte pas de brins 22 de fil sortant, mais forme un enroulement s'étendant strictement sur le cadre mobile 14. La bobine 15 se termine par ses deux extrémités situées sur le cadre mobile 14, au voisinage immédiat d'une des poutres de torsion 12. Les extrémités viennent contacter deux pistes métalliques 29 transitant par la poutre de torsion 12 pour rejoindre les plots d'alimentation 23 sur le cadre fixe 11. Les pistes métalliques 29 sont déposées, par exemple, par un procédé de pulvérisation ou par un procédé PVD (de l'anglais Plasma Vapor Déposition) sur la poutre de torsion 12. Les extrémités de la bobine 15 sont soudées aux pistes métalliques 29 de sorte qu'aucun brin de fil ne sort de la bobine 15. Dans ce mode de réalisation, le mouvement de rotation de l'actuateur 10 n'est nullement perturbé, que ce soit en mode statique ou en mode dynamique, car les pistes métalliques 29 sont confondues aux poutres 12 et ont une constante de raideur $k_{lignes}$ négligeable devant la constante de raideur des poutres 12.

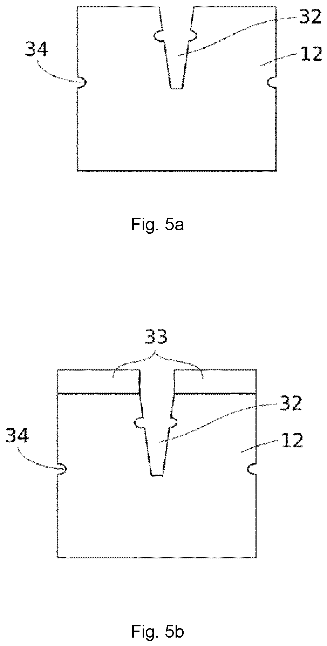

Pour réaliser plusieurs pistes de métal 29 passant par l'une des poutres de torsion 12, il n'est pas possible d'utiliser un masque à ombre lors du dépôt de la couche métallique, car la distance séparant les deux pistes 29 est de l'ordre du micron et la résolution du masque à ombre est plutôt de 100 microns, ce qui rend la séparation des deux pistes 29 impossible. Il faudrait alors en principe, pour parvenir à former les deux pistes 29, graver le métal sur toute la longueur de la poutre 12 et sur une largeur d'un micron, par un procédé de photolithographie. Or, ce procédé est long et complexe, et de plus, il nécessite des installations coûteuses. La présente invention se propose de surmonter cette difficulté par un procédé ingénieux. Comme déjà mentionné précédemment, un procédé de photolithographie est employé lors de la fabrication du dispositif micromécanique 1 à partir d'une plaquette de silicium. Lors de cette opération, l'actuateur 10, le cadre fixe 11, les poutres de torsion 12 et le cadre mobile 14 sont découpés dans la plaquette sur une profondeur de 200 microns environ. On tire alors parti d'une propriété de procédé de la gravure RIE (de l'anglais Reactive Ion Etching) pour préparer, dès ce stade de la fabrication du dispositif micromécanique 1, la formation des deux pistes métalliques 29. En effet, la vitesse de gravure du procédé RIE varie en fonction de la largeur du motif à graver. Pour un motif d'une largeur de 1 micron, l'attaque est environ deux fois moins rapide que pour un motif de largeur 20 microns et plus. On grave alors une fine fente 32 d'une largeur de 2 micron le long de la poutre 12 et de profondeur environ la moitié de l'épaisseur de la poutre 12, tel que représenté en coupe en figure 5a. Pour rendre le silicium isolant on fait croître une fine couche isolante d'une épaisseur d'environ 0.1 um ; par exemple par oxidation thermique ou par un autre procédé bien connu de l'homme du metier.

Lors de l'étape de dépôt de métal sur le dispositif micromécanique 1, le métal 33 se dépose de part et d'autre de la fente 32 mais pas à l'intérieur de celle-ci en raison du ratio faible entre la largeur de la fente 32 et sa profondeur. Ce phénomène est illustré en figure 5b. On a donc réalisé deux pistes métalliques 29 courant sur l'une des poutres de torsion 12, en faisant l'économie d'une étape de photolithographie de la couche de métal 33. Par construction, les pistes de métal 29 sont séparées et isolées par une fente 32 de profondeur supérieure à 5 fois sa largeur.

On note que le procédé de gravure RIE est directionnel, c'est pourquoi les parois gravées, de la poutre 12 et de la fente 32, sont sensiblement verticales. On peut cependant effectuer une courte étape de gravure isotropique aux environs de la moitié de la gravure afin d'effectuer une petite encoche 34 dans la paroi gravée. Cette encoche 34 permet d'éviter tout court-circuit potentiel entre les pistes de métal 29, lequel pourrait se produire si une très faible quantité de métal se dépose à l'intérieur de la fente 32. L'encoche 34 interrompt l'éventuelle fine couche métallique formée le long des parois de la fente 32.

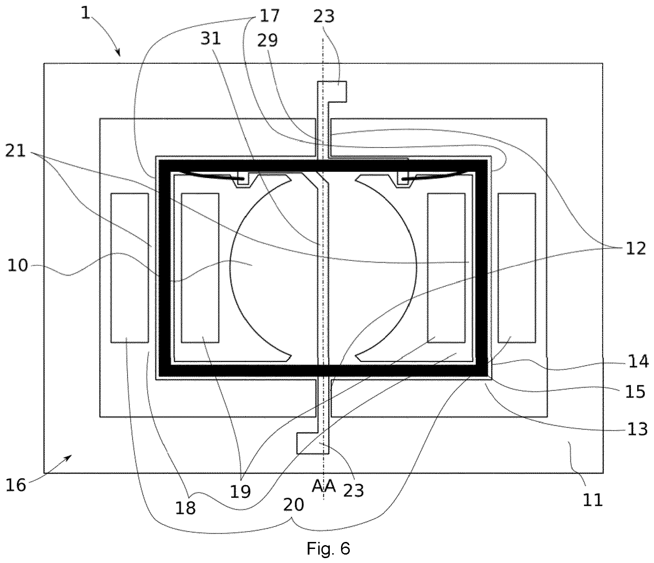

Dans certains cas, il peut s'avérer impossible de faire transiter deux pistes métalliques par une même poutre de torsion. En effet, en fonction du courant requis pour le fonctionnement du dispositif micromécanique à bobine 1, les pistes métalliques 29 peuvent être trop larges pour s'étendre parallèlement sur la largeur de 50 micromètres d'une poutre de torsion 12. Or, la bobine 15 doit faire un nombre entier d'enroulement sur le cadre mobile 14 afin que la masse du fil soit répartie symétriquement par rapport à l'axe de rotation AA. De ce fait, les deux extrémités de la bobine 15 se trouvent nécessairement au voisinage d'une même poutre de torsion 12, et il n'est pas possible de faire transiter l'une des pistes métalliques 29 par une première poutre 12 et l'autre par la seconde poutre 12. La solution à cette difficulté est illustrée en figure 6. Sur cette variante du deuxième mode de réalisation du dispositif micromécanique 1, la bobine 15 forme, sur le cadre mobile 14, un enroulement dont les deux extrémités se situent au voisinage de l'une des poutres de torsion 12. Une première extrémité est reliée à une première piste métallique 29 laquelle transite par la poutre de torsion 12 la plus proche, tandis qu'une deuxième extrémité est reliée à une deuxième piste métallique 31, laquelle rejoint la poutre de torsion 12 opposée via l'actuateur 10. Notons que la bobine 15 et les pistes métalliques 29, 31 sont situées à l'arrière de la face active de l'actuateur 10, ce qui évite toute interaction entre un faisceau lumineux et la ligne conductrice 31. Grâce à cet agencement, chacune des poutres de torsion 12 ne supporte qu'une seule piste métallique 29, 31, et la masse de l'ensemble est répartie symétriquement par rapport à l'axe de rotation AA, étant entendu que la masse des lignes conductrices 29, 31 est négligeable devant la masse du cadre mobile 14 et de la bobine 15. Les pistes métalliques 29, 31 sont ainsi d'une largeur pouvant avoisiner la largeur des poutres de torsion 12, et peuvent transporter un courant plus important que dans la variante représentée en figure 4.

**Revendications**

1. Dispositif micromécanique à bobine (1) comportant :

  - un cadre fixe (11),
  - un rotor (13) monté mobile selon un axe de rotation AA sur ledit cadre fixe (11) par l'intermédiaire de deux poutres de torsion (12) d'axe AA, et
  - une bobine de fil conducteur (15), sur un cadre mobile (14), montée solidaire en rotation dudit rotor (13), ladite bobine (15) étant alimentée en courant depuis ledit cadre fixe (11) via deux segments conducteurs (29) lesquels sont reliés à des plots d'alimentation (23) disposés sur ledit cadre fixe (11),
  - lesdits segments conducteurs étant formés par deux pistes métalliques (29) s'étendant sur une unique poutre de torsion (12),

**caractérisé en ce que** ladite poutre de torsion (12) comprend une fente longitudinale (32) qui sépare électriquement lesdites pistes métalliques (29) et **en ce que** les deux extrémités de ladite bobine (15) sont reliées chacune à l'une des pistes métalliques (29) de part et d'autre de l'une des poutres de torsion sur le cadre mobile (14).

2. Dispositif micromécanique à bobine (1) selon la revendication 1, **caractérisé en ce qu'**une encoche (34) est formée dans les parois de la fente (32) environ à miprofondeur de ladite fente (32).

**Patentansprüche**

1. Mikromechanische Spulenvorrichtung (1), umfassend:

- einen feststehenden Rahmen (11),
- einen Rotor (13), der am genannten feststehenden Rahmen (11) mit Hilfe zweier Torsionsbalken (12) einer Achse AA um die Rotationsachse AA beweglich montiert ist, und
- eine Spule aus leitfähigem Draht (15) auf einem beweglichen Rahmen (14), die für gemeinsame Drehungen mit dem genannten Rotor verbunden montiert ist, wobei die genannte Spule (15) vom genannten feststehenden Rahmen (11) aus über zwei leitfähige Abschnitte (19) mit Strom versorgt wird, die mit Speisekontakten (23) verbunden sind, die sich auf dem genannten feststehenden Rahmen (11) befinden,
- wobei die genannten leitfähigen Abschnitte aus zwei Metallbahnen (29) bestehen, die über einen einzigen Torsionsbalken (12) verlaufen,

**dadurch gekennzeichnet, dass** der genannte Torsionsbalken (12) einen Schlitz in Längsrichtung (32) aufweist, der die genannten Metallbahnen (29) elektrisch trennt, und dass die beiden Enden der genannten Spule (15) jeweils an eine der Metallbahnen (29) beiderseits eines der Torsionsbalken am beweglichen Rahmen (14) angeschlossen sind.

2. Mikromechanische Vorrichtung mit Spule (1) nach Patentanspruch 1, **dadurch gekennzeichnet, dass** eine Kerbe (34) in den Wänden des Schlitzes (32) ungefähr in halber Tiefe des genannten Schlitzes (32) ausgebildet ist.

**Claims**

1. Coil micromechanical device (1) comprising:

- a fixed frame (11),
- a rotor (13) movably mounted along an axis of rotation AA on said fixed frame (11) by means of two torsion beams (12) with an axis AA and
- a coil made of conducting wire (15) on a mobile frame (14), integrally mounted rotatable with said rotor (13), said coil (15) being supplied with current from said fixed frame (11) via two conducting segments (29) that are connected to supply studs (23) placed on said fixed frame (11), said conducting segments being formed by two metallic paths (29) extending on a single torsion beam (12),

**characterized in that** said torsion beam (12) comprises a longitudinal slit (32) that electrically separates said metallic paths (29) and **in that** both ends of said coil (15) are each connected to one of the metallic paths (29) on both sides of one of the torsion beams on the mobile frame (14).

2. Coil micromechanical device according to claim 1, **characterized in that** a notch (34) is formed in the walls of the slit (32) approximately at half depth of said slit (32).

Fig. 1

Fig. 2

Fig. 3

Fig. 4

Fig. 5a

Fig. 5b

Fig. 6

**EP 3 702 321 B1**

**RÉFÉRENCES CITÉES DANS LA DESCRIPTION**

**Documents brevets cités dans la description**

- EP 2990375 B1

- WO 2013065126 A